# EUROPEAN PATENT APPLICATION

(11) **EP 2 172 424 A1**
(43) Date of publication of application: **07.04.2010**
(21) Application number: 08765285.5
(22) Date of filing: 06.06.2008
(51) Int. Cl.: C01B 33/037

(54) **METHOD OF SOLIDIFYING METALLIC SILICON**

(30) Priority: 08.06.2007 JP 2007152294
(71) Applicant: Shin-Etsu Chemical Co., Ltd., Tokyo 100-0004 (JP)
(72) Inventor: YAMADA, Motoyuki, Annaka-shi Gunma 379-0195 (JP); HATAYAMA, Kazuhisa, Annaka-shi Gunma 379-0195 (JP)
(74) Representative: Stoner, Gerard Patrick
(86) International application number: PCT/JP2008/060472
(87) International publication number: WO 2008/149985

(57) **Abstract**

A method of solidifying metallic silicon, **characterized by** monodirectionally solidifying a metallic silicon of 800 ppm or less iron concentration. Any metal impurity components of the metallic silicon can be effectively removed with reduced cost through shortened steps.

## Description

### TECHNICAL FIELD

This invention relates to a method of industrially manufacturing higher purity metallic silicon, and more particularly, to a method of achieving higher purity by unidirectional solidification.

### BACKGROUND ART

While fossil fuel is regarded as the energy source that discharges CO₂ to promote the global greenhouse effect, a number of energy sources have been proposed and implemented as the substitute for the fossil fuel. Among others, solar power generation is advantageous in that electricity is produced by the energy available everywhere on the earth, a plant of relatively small scale is acceptable, and practical implementation has a long history. The amount of electricity produced by solar plants is annually increasing.

While various methods are known for solar power generation, a solar cell having an array of photovoltaic cells made of silicon wafers is the most widespread solar power generation system. The silicon used as silicon wafers in the solar cell has an impurity concentration which need not be as low as the impurity concentration of silicon used for semiconductor devices. Specifically, it is believed that the necessary purity of silicon for use in semiconductor devices should be as low as possible, with a purity of 99.999999999% being required, whereas it is believed acceptable that the silicon for use in the solar cell may have a purity of 99.9999%.

The feedstocks used in the prior art in order that the silicon for use in the solar cell have such an impurity level include 99.999999999% pure silicon for semiconductor use and in addition, silicon materials obtained by reprocessing and purifying so-called off-grade materials to be discarded as impurity-enriched or foreign matter-containing material in the semiconductor silicon manufacturing process.

Specifically, while the silicon for use in the solar cell may have a lower purity than the silicon for semiconductor use, its supply source originates from the silicon for semiconductor use or derivatives thereof. For this reason, the supply amount of silicon for use in the solar cell is influenced by the semiconductor industry, indicating a separation between the silicon demand in the solar cell industry featuring a higher growth rate than the semiconductor industry and the supply amount of silicon for solar cell use outflowing from the semiconductor industry. This eventuates in a short supply to meet the silicon demand for solar cell use.

Therefore, research has been made to increase the purity of metal silicon which is commercially manufactured in a fully large quantity, so that it may be used as silicon for solar cell use.

Metal silicon contains impurities which are mainly metal elements such as iron, aluminum, calcium and titanium and non-metallic elements such as boron and phosphorus serving as a dopant. Of these impurities, the metal elements are removed by such purification techniques as dissolving away by acid pickling, metallurgical refinement with flux, and smelting-solidification in terms of a partition coefficient for solidification.

Of these, the purification technique utilizing solidification segregation of silicon at the solid-liquid phase interface is an effective purification technique capable of removing many metal element impurities at a time. One exemplary technique of producing higher purity silicon utilizing solidification segregation is by moving a silicon melt in a furnace in one direction for solidification wherein impurity components are displaced to the liquid phase side whereby solidified silicon is of higher purity, as described in JP-A H10-182137 (Patent Document 1). Although this technique includes a cumbersome step to melt silicon once, it has the advantage that high purity silicon is obtained from the initial to middle stages of silicon solidification because most metal components have very low partition coefficients between them and silicon.

This technique is further described. With regard to the solidification segregation phenomenon of impurity metal elements in silicon material at the solid-liquid phase interface, the segregation state is dictated by a partition coefficient for solidification. A lower partition coefficient for solidification ensures that less of impurity metal elements are captured in the solid phase, and more are shifted to the liquid phase side. This behavior of impurity metal elements leads to a reduction in the impurity concentration of the solid phase. Many impurity metal elements in silicon have very low partition coefficients for solidification, for example, iron which is present in the largest amount among impurity elements in metal silicon has a partition coefficient for solidification which is at most 8×10⁻⁶. Therefore, solid silicon has a low iron concentration at the initial stage of solidification, and a gradually increasing iron concentration from middle to final stages of solidification. If a portion having the desired iron concentration is selected from a cast mass by utilizing this solidification segregation phenomenon, silicon having a low iron concentration is obtained. As to any impurity metal element other than iron, silicon having a low impurity concentration is similarly obtained.

This is elucidated in detail. In order that impurities be segregated in silicon by utilizing solidification segregation, unidirectional solidification of silicon is adopted. This method includes (1) a method of moving a crucible charged with molten silicon downward in a furnace wherein the molten silicon in the crucible experiences from its bottom a sufficient temperature drop to initiate solidification, and solidification proceeds directionally from the bottom to the top with the further downward movement of the crucible, (2) a method of placing a cooling mechanism at or near the bottom of a crucible in a furnace, wherein the cooling mechanism serves to remove heat from the crucible bottom so that solidification proceeds from the bottom to the top, (3) a method of placing a crucible in a furnace at such a position as to provide a temperature profile in the furnace that the temperature is lower at the crucible bottom than at the crucible top, and descending the set temperature of the furnace to incur a furnace temperature lowering from the crucible bottom whereby solidification takes place in the molten silicon from the bottom toward the top, and (4) a combination of these methods. All these methods aim to achieve unidirectional solidification wherein solidification of silicon starts from the crucible bottom and proceeds toward the top.

In the unidirectional solidification, the solid-liquid phase interface generally shifts from the bottom to the top. At this interface, impurity components are partitioned in solidified and liquid phases in accordance with their partition coefficient for solidification. However, since most metal elements remain in the liquid phase as mentioned above, the concentration of metal impurity elements in the liquid phase increases. Particularly in proximity of the solid-liquid phase interface, metal impurity elements which are displaced by the solid phase and left in the liquid phase are present in high concentrations. This high concentration portion becomes a bar against the exclusion of metal impurity elements utilizing the solidification segregation phenomenon. Namely, the high concentration portion at the solid-liquid phase interface is such that its concentration controls the exclusion of impurities in accord with a partition coefficient for solidification. This leads to partition at a higher impurity concentration than the bulk impurity concentration of the liquid phase, failing to achieve full exclusion of impurities. Too fast a cooling rate brings about an excessively high concentration state, inducing a compositional supercooling phenomenon on the liquid phase side.

The compositional supercooling phenomenon indicates that when impurity diffusion at the solid-liquid interface is insufficient, a substantial difference arises between the impurity concentration in proximity of the interface and the concentration of liquid phase bulk to provide a supercooled composition. If a compositional supercooling phenomenon occurs, movement of solidification interface does not become stable. This does not result in impurity movement at the solid-liquid interface in accord with its partition coefficient for solidification, and thus the impurity concentration in the solid phase increases discontinuously.

While unidirectional solidification methods capable of preventing a compositional supercooling phenomenon include agitation of melt, lowering of a solidification rate, and an increase of temperature gradient, the essentially most effective means is by lowering the impurity concentration in silicon.

With respect to the techniques of producing higher purity silicon by unidirectional solidification, one prior art technique that refers to a specific impurity concentration is described in JP-A H10-236815 (Patent Document 2) as using metal silicon as a feedstock, and admixing off-grade silicon from the semiconductor industry with the metal silicon so that the impurity content of the feedstock used in the manufacture of silicon for solar cell is P s 30 ppm, B s 20 ppm, Al ≤ 1000 ppm, Fe ≤ 1000 ppm, C s 500 ppm, and Ti s 60 ppm. Allegedly this suppresses variations among lots and reduces the load in the purifying step, thus producing silicon of the desired purity in a consistent manner.

In Patent Document 2, the adjustment of impurity concentration is achieved simply by admixing off-grade silicon having a higher purity than the metal silicon. The elements of interest are as many as six. No findings relating to purity and solidification state are described.

JP-A H10-120493 (Patent Document 3) discloses a method of assigning a specific equation to each of impurity elements Al, Fe and Ti, and determining a solidification rate in accordance with the equation. As seen from Examples in Patent Document 3, only Al, Fe and Ti concentrations of up to 100 ppm are discussed. In ordinary metal silicon, the Al, Fe and Ti concentrations cannot be up to 100 ppm. Inclusion of impurities at a level of several hundreds to several thousands ppm as in the present invention is not considered in Patent Document 3.

JP-A H10-182134 (Patent Document 4) discloses a technique of using metal silicon containing less than 1000 ppm of Fe and less than 1000 ppm of Al, removing P through vacuum melting, removing B and C with an oxidizing gas, and removing Fe, Al, Ca and Ti through solidification refinement. The metal silicon as the starting feed is previously purified in order to adjust to the prescribed concentration, or the metal silicon with the prescribed concentration is obtained using metal impurity-poor powdered silicon slag.

However, these methods are still unsatisfactory. There is a need for a method of removing impurities from metal silicon in an economical and efficient manner.

Patent Document 1: JP-A H10-182137
Patent Document 2: JP-A H10-236815
Patent Document 3: JP-A H10-120493
Patent Document 4: JP-A H10-182134

### DISCLOSURE OF THE INVENTION

### Problem to be Solved by the Invention

An object of the present invention which has been made under the above-discussed circumstances is to provide a method for effectively removing impurities in silicon through a smaller number of steps at low cost while overcoming the drawbacks of the prior art.

### Means for Solving the Problem

Making extensive investigations to solve the outstanding problems and research efforts on the effective removal of metal impurities in metal silicon, the inventors have found that iron, a component having the highest concentration among impurities present in metal silicon, is the predominant element that causes a compositional supercooling phenomenon to occur because of its high concentration, and that the occurrence of a compositional supercooling phenomenon can be restrained by controlling the iron concentration. Namely, it has been found that when a metallic silicon having an iron concentration of not more than 800 ppm is subjected to unidirectional solidification, impurities in a solidified ingot can be effectively concentrated; when a feed material for the manufacture of metal silicon is properly selected, a metallic silicon having an iron concentration of not more than 800 ppm can be manufactured from silicon drained from a metal silicon furnace; and when this metallic silicon is used in unidirectional solidification, metal impurity components can be effectively removed through a smaller number of steps at low cost.

Specifically, silicon materials, known as metal silicon, which are manufactured by heating silica stone as a silicon source and carbon material as a reducing agent in a submerged arc furnace for effecting reaction usually contain about 1500 to 5000 ppm of iron component. One origin of this iron component is iron component present in silica stone as the silicon source and charcoal or other carbon material migrating to the silicon produced by in-furnace reaction. Additionally iron component is incidentally introduced from the process during operation, for example, when a vessel made of steel comes in contact with the feed material for metal silicon, iron component migrates to the feed material. From these origins, iron component is contained in metal silicon. Accordingly, if silica stone and carbon material which are artificially controllable feed materials for metal silicon are selected by carefully considering their impurity contents, then metal silicon having minimal impurity metal contents can be obtained. With respect to both silica stone and carbon material, materials having low impurity concentrations are rare, high in unit price, and restricted in available quantity, as compared with the materials commonly used as feedstock. Accordingly, an attempt to produce metal silicon of high purity by resorting to any possible measures is irrational from the aspects of unit price, production capacity and productivity. There is a need for metal silicon having a practically reasonable impurity concentration.

Paying attention to the impurity concentration of silicon which can be industrially manufactured as metal silicon and the solidification step of silicon, the inventors have investigated the effect of iron being excluded upon solidification, the iron having the highest concentration among metal impurities in metal silicon. The inventors have found that when a metal silicon having an iron concentration of not more than 800 ppm is unidirectionally solidified, a significant difference is noticed with respect to the occurrence of a compositional supercooling phenomenon, as compared with metal silicon having an iron concentration in excess of 800 ppm, and that a metal silicon having an iron concentration of not more than 800 ppm is available as the metal silicon manufactured in a submerged arc furnace. The invention is predicated on these findings.

The present invention provides a method of solidifying metallic silicon, as defined below.
(1) A method of solidifying metallic silicon, comprising unidirectionally solidifying a metallic silicon having an iron concentration of not more than 800 ppm.
(2) A method of solidifying metallic silicon according to (1) wherein the metallic silicon has been prepared by using silicon oxide and carbon material as feed material, adjusting the impurity concentration of the feed material, and then reducing the silicon oxide.
(3) A method of solidifying metallic silicon according to (1) wherein the metallic silicon is obtained by blending at least two metallic silicon feeds having different iron concentrations.
(4) A method of solidifying metallic silicon according to (1), (2) or (3) wherein the metallic silicon has been drained from a submerged arc furnace.
(5) A method of solidifying metallic silicon according to any one of (1) to (4) wherein the metallic silicon has an iron concentration of not less than 300 ppm.

### Advantageous Effects of the Invention

According to the invention, metal impurity components in metal silicon can be effectively removed through a smaller number of steps at low cost.

### BRIEF DESCRIPTION OF DRAWINGS

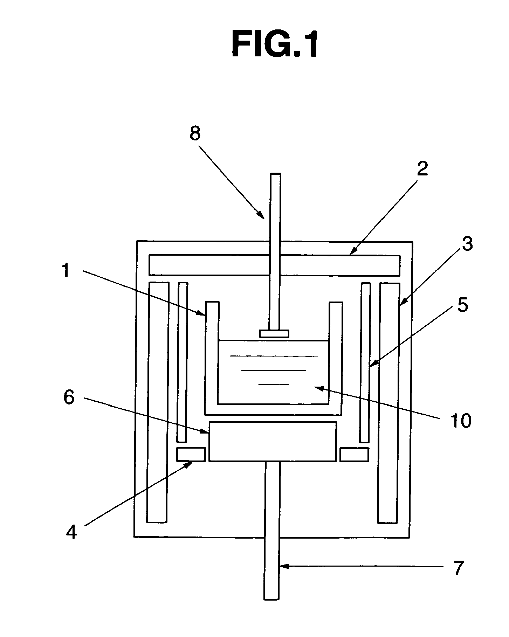

FIG. 1 is a schematic view of a furnace used in one embodiment of the invention.

### BEST MODE FOR CARRYING OUT THE INVENTION

The method of solidifying metallic silicon according to the invention comprises unidirectionally solidifying a metal silicon having an iron concentration of not more than 800 ppm.
First the metal silicon used herein is described. The metal silicon used in the unidirectional solidification method may be prepared by heating silica stone (silicon oxide) as a silicon source and carbon material (charcoal) as a reducing agent in a submerged arc furnace for effecting reaction. The silicon prepared in the submerged arc furnace contains Fe, Ti, Al, and Ca as main impurities. As discussed above, these impurity components are carried over from the feed materials, and in general, they are incidental to the feed materials for use in metal silicon manufacture. Among these components, however, Al and Ca are components whose content can be readily reduced by about 50 to 90% by blowing in situ an oxidizing gas (e.g., oxygen or steam) into a silicon melt drained from the submerged arc furnace. This method is easy and inexpensive because the silicon melt as drained can be directly treated and the same handling as the metal silicon material drained from the submerged arc furnace is possible.

Besides this method, for example, a method of removing impurity metal components by contacting flux with silicon melt, a method of removing an impurity having a high vapor pressure by smelting silicon in vacuum, or a similar method for reducing impurities in metal silicon may be adopted as the previous step prior to the solidification method of the invention. The contents of impurities other than iron such as Ti, Al, and Ca in the metal silicon used herein are each preferably a concentration equal to or less than 1/2 of the iron concentration, and more preferably a concentration equal to or less than 1/3 of the iron concentration. Specifically, the Ti concentration is preferably 400 to 100 ppm, and more preferably 250 to 100 ppm; the Al concentration is preferably 400 to 20 ppm, and more preferably 100 to 20 ppm; and the Ca concentration is preferably 100 to 10 ppm, and more preferably 50 to 10 ppm. If too much, the occurrence of a compositional supercooling phenomenon is not fully controllable, and the impurity removing effect ceases midway the solidification process. If the impurity contents are too low, the phenomenon is effectively suppressed, but the removal of these impurities from silicon leads to an increased cost.

The metal silicon manufactured in a submerged arc furnace generally has an impurity (iron) concentration of 1500 ppm to 5000 ppm as described above, whereas the metal silicon used herein has an iron concentration of not more than 800 ppm. Since the concentration of impurity in metal silicon largely depends on the concentration in the feed material as described above, metal silicon of high purity can be prepared from a high-purity product which has been selectively manufactured as the feed material. For example, if quartz or chemically synthesized silicon dioxide is used instead of silica stone, or if charcoal from which ash has been removed by acid treatment is used as the carbon material, purification can be accomplished to a certain extent.

However, this gives rise to the problem that the unit price of metal silicon itself increases as the feed material costs higher. Thus the silicon solidification method of the invention favors to omit use of the metal silicon manufactured from expensive feed materials having such a high purity that silicon drained from the submerged arc furnace may have an iron concentration of less than 300 ppm. Therefore, the feed materials (silica stone and carbon material) used in the invention preferably have an iron content of 0.004 to 0.015 ppm, especially 0.004 to 0.01 ppm.

Also, by combining two or more metal silicon materials having different iron concentrations as produced in a submerged arc furnace, a metal silicon having a certain content of iron as prescribed above is obtainable. It may be used in the directional solidification method of the invention.
It is noted that the impurity concentration may be measured by an inductively coupled plasma spectrometry instrument (ICP-AES) or the like.

Referring to the drawing, one embodiment of the metal silicon solidification method of the invention is described.
FIG. 1 illustrates one exemplary furnace used in the directional solidification method of the invention. In FIG. 1, a crucible 1 for melting silicon is disposed at the center of a furnace comprising thermal insulators 2, 3, a thermal barrier 4, and a heater 5 disposed inside thermal insulator 3. The crucible 1 is supported by a platform 6 on a vertically movable shaft 7. A rod 8 is disposed above crucible 1 for detecting the position of a solid-liquid interface. The heater 5 is connected to a power supply (not shown), and movable shaft 7 and rod 8 are coupled to drive units (not shown), respectively.

The crucible 1 as a smelting vessel is charged with silicon 10. The material of which crucible 1 is made may be selected from fire-proof materials, for example, refractories including graphite, quartz glass, alumina, silicon carbide, silicon nitride, magnesia, and zirconia. The crucible is disposed in the space in the furnace surrounded by thermal insulators 2, 3 and thermal barrier 4, where heater 5 is disposed. The furnace heating systems include a resistance heating electric furnace, high-frequency induction furnace, gas furnace, plasma furnace, and the like. Since a gas furnace is not easy to melt silicon because of the relatively high melting point of silicon, it is preferred to use electric furnaces with a supply of electricity as the energy source. Among others, a resistance heating electric furnace is appropriate because of a relatively low installation cost and a high power efficiency. The resistance heating electric furnace is contemplated in FIG. 1 although the invention is not limited to FIG. 1 and this heating system.

The electric furnace is heated by conducting electricity across heater 5, and the silicon material is melted when the furnace is heated at or above 1450°C, the melting point of silicon. The melted silicon 10 is preferably held in the molten state for a certain time so that the melt may become homogeneous in composition. Since a higher holding temperature is more effective to promote homogenization of molten silicon, the holding temperature is preferably higher than the melting point by at least 20°C, especially by 50°C to 100°C.

Now that the molten silicon in the crucible has a homogeneous composition, shaft 7 is moved down to move the crucible downward of the furnace. Since thermal barrier 4 thermally shields the space beneath the furnace from the space surrounded by heater 5, the temperature within the furnace experiences a sudden drop at a position below thermal barrier 4. The crucible or molten silicon therein is cooled from its bottom as it is moved past the thermal barrier, and solidification commences. Herein, it is also possible that the silicon is solidified from the crucible bottom by lowering the furnace temperature together with the downward movement of the crucible.

At the solid-liquid phase interface of the silicon mass that has commenced solidification, the solid phase region spreads with the lapse of time, and impurity metal components in the silicon mass are continuously excluded to the liquid phase. As a result, the impurity metal components become enriched in a very thin region in proximity of the interface. This enrichment gradually takes place with the progress of solidification. When the concentration reaches the compositional supercooling state relative to the temperature of silicon, solidification undergoes a sudden progress, which makes discontinuous the impurity excluding mechanism during solidification, so that impurity metal components are suddenly taken into the solid phase.

In the method of the invention, the descending rate of the crucible (moving speed of solid-liquid phase interface in solidification direction) is preferably in a range of 1 mm/hr to 50 mm/hr, more preferably 2 mm/hr to 10 mm/hr, even more preferably 2 mm/hr to 8 mm/hr, specifically up to 7 mm/hr, and most preferably up to 6 mm/hr. If the moving speed of solid-liquid phase interface in solidification direction is too high, a supercooling phenomenon may occur even with the method of the invention. If the moving speed is too low, the cycle time may become too long, leading to a productivity drop.

The above description is made in connection with the technique of vertically moving the crucible containing molten silicon to commence and advance solidification and to move the solid-liquid phase interface. Aside from this technique, (a) a technique of descending the set temperature of the electric furnace for cooling the crucible, (b) a technique of forcedly cooling the crucible bottom for achieving cooling from the crucible bottom, and (c) a combination of these techniques may be employed for similarly moving the solid-liquid phase interface during the solidification process. Of these techniques, the technique of vertically moving the crucible is preferred in the practice of the invention because the movement of the crucible is directly reflected by the movement of the solid-liquid phase interface. With the other techniques, the inventive method can be implemented because the position of the solid-liquid phase interface can be accurately detected by vertically moving the rod 8 (FIG. 1) made of a refractory material such as graphite toward and away from the Si melt from without the furnace, that is, the cooling rate or the solid-liquid phase interface position can be confirmed as with the crucible moving technique.

Since the condition under which a compositional supercooling phenomenon occurs depends on not only the impurity concentration as in the invention, but also the cooling rate, agitation of melt, diffusion of impurity component in melt, and the like, the condition of occurrence is determined relatively among conditions associated with solidification. However, if the remaining conditions are the same, a specific condition, i.e., a difference in impurity concentration in the invention may be employed as the difference governing the occurrence of compositional supercooling phenomenon.

### EXAMPLE

Examples and Comparative Examples are given below for further illustrating the invention although the invention is not limited thereto. It is noted that the impurity concentration in metal silicon was measured by an inductively coupled plasma spectrometry instrument ICP-AES (Perkin Elmer).

### [Manufacture of metal silicon]

### Manufacture of MG-1

A feed material consisting essentially of silica stone containing 150 ppm calculated as Fe₂O₃ of iron and 140 ppm calculated as TiO₂ of titanium and charcoal containing 1% calculated as Fe₂O₃ of iron and 0.2% calculated as TiO₂ of titanium as ash was admitted in a submerged arc furnace, where metal silicon was produced. This metal silicon contained iron and titanium in a concentration of 700 ppm and 160 ppm, respectively.

### Manufacture of MG-2

Similarly a feed material consisting essentially of silica stone containing 900 ppm calculated as Fe₂O₃ of iron and 510 ppm calculated as TiO₂ of titanium and charcoal containing 1% calculated as Fe₂O₃ of iron and 0.7% calculated as TiO₂ of titanium as ash was admitted in a submerged arc furnace, where metal silicon was produced. This metal silicon contained iron and titanium in a concentration of 1500 ppm and 750 ppm, respectively.

### [Solidification of metal silicon]

### Example 1

A quartz crucible having inner dimensions of 180 mm square and 300 mm deep was charged with 10 kg of metal silicon MG-1 manufactured by the above procedure and placed in a resistance-heating electric furnace as shown in FIG. 1. Once the electric furnace was evacuated to vacuum, argon was introduced until atmospheric pressure was resumed, and argon was continuously introduced. Electricity was conducted across the furnace with a preset temperature of 1500°C. After the furnace temperature reached 1500°C, the furnace was held at the temperature for 2 hours. Thereafter, the crucible was descended at a rate of 5 mm/hr whereby the total mass of Si was solidified.

Several regions of the resulting Si ingot were analyzed to find that metal impurities were concentrated in an upper portion of the ingot as seen from Table 1. The solidified structure was observed under an optical microscope, finding that the secondary phase which was an agglomerate of impurities concentrated in the region of 1 mm from the ingot top while the secondary phase was not observed in regions other than the top-most region.

Since the analysis sample from the ingot top in Table 1 is taken out from a region excluding the secondary phase-segregated region, the analytic data represent bulk silicon analysis. Hereinafter, analytic data of "ingot top" are those of a sample taken out from a region excluding the top-most region where the secondary phase segregates. The top, top-middle, middle, middle-bottom, and bottom regions of the ingot correspond to those regions extending 5-15 mm, 30-40 mm, 55-65 mm, 80-90 mm, and 105-115 mm from the ingot top end assigned 0 mm.

**Table 1**

| Ingot | Fe | Al | Ca | Ti |
|---|---|---|---|---|
| Top | 8.5 | 37 | 0.53 | 4.3 |
| Top-middle | 0.09 | 6.4 | 0.2 | 0.01 |
| Middle | 0.04 | 6.3 | 0.16 | 0.01 |
| Middle-bottom | 0.05 | 2.3 | 0.08 | 0.01 |
| Bottom | 0.02 | 2.3 | 0.15 | <0.01 |

| | | | | |
|---|---|---|---|---|
| Unit: ppm | | | | |

### Examples 2, 3 and Comparative Examples 1, 2

By mixing MG-1 and MG-2, metal silicon materials were prepared having a Fe concentration of 700 ppm, 800 ppm, 900 ppm, and 1000 ppm. Using the same electric furnace and crucible as in Example 1, the metal silicon materials were subjected to unidirectional solidification at a descending rate of 1.5 mm/hr, 2.5 mm/hr, 5 mm/hr, and 10 mm/hr. The solidified ingots were analyzed as in Example 1 to see the occurrence of a compositional supercooling phenomenon.
Table 2 shows the analytical data of Fe in a sample from the top-middle region of the ingot. As seen from Table 2, for those materials having a Fe concentration in excess of 800 ppm, the concentration of the top-middle region is high even at a descending rate of 2.5 mm/hr, with no impurity excluding effect observed. For those materials having a Fe concentration equal to or less than 800 ppm, a compositional supercooling phenomenon does not occur even at a descending rate of 5 mm/hr, indicating a satisfactory impurity excluding effect.

**Table 2**

| | Fe concentration | 1.5 mm/hr | 2.5 mm/hr | 5 mm/hr | 10 mm/hr |
|---|---|---|---|---|---|
| Example 2 | 700 ppm | 0.04 | 0.05 | 0.09 | 1200 |
| Example 3 | 800 ppm | 0.05 | 0.06 | 0.07 | 1500 |
| Comparative Example 1 | 900 ppm | 0.09 | 1700 | 2000 | 1500 |
| Comparative Example 2 | 1000 ppm | 0.12 | 1800 | 1900 | 1700 |

| | | | | | |
|---|---|---|---|---|---|
| Unit: ppm | | | | | |

## Claims

1. A method of solidifying metallic silicon, comprising unidirectionally solidifying a metallic silicon having an iron concentration of not more than 800 ppm.

2. A method of solidifying metallic silicon according to claim 1 wherein the metallic silicon has been prepared by using silicon oxide and carbon material as feed material, adjusting the impurity concentration of the feed material, and then reducing the silicon oxide.

3. A method of solidifying metallic silicon according to claim 1 wherein the metallic silicon is obtained by blending at least two metallic silicon feeds having different iron concentrations.

4. A method of solidifying metallic silicon according to claim 1, 2 or 3 wherein the metallic silicon has been drained from a submerged arc furnace.

5. A method of solidifying metallic silicon according to any one of claims 1 to 4 wherein the metallic silicon has an iron concentration of not less than 300 ppm.
